Europäisches Patentamt

European Patent Office

Office européen des brevets

(11) Veröffentlichungsnummer : **0 067 156**
**B1**

(12) **EUROPÄISCHE PATENTSCHRIFT**

(45) Veröffentlichungstag der Patentschrift :
09.10.85

(51) Int. Cl.⁴ : **H 02 M 9/00**

(21) Anmeldenummer : **81902047.0**

(22) Anmeldetag : **30.07.81**

(86) Internationale Anmeldenummer :
**PCT/CH 81/00087**

(87) Internationale Veröffentlichungsnummer :
**WO/8202295 (08.07.82 Gazette 82/17)**

(54) SCHALTUNGSANORDNUNG ZUM ERZEUGEN VON HOCHLEISTUNGSIMPULSEN AUS EINEM INDUKTIVEN ENERGIESPEICHER.

(30) Priorität : **22.12.80 CH 9452/80**

(43) Veröffentlichungstag der Anmeldung :
**22.12.82 Patentblatt 82/51**

(45) Bekanntmachung des Hinweises auf die Patenterteilung : **09.10.85 Patentblatt 85/41**

(84) Benannte Vertragsstaaten :
**CH DE FR GB LI**

(56) Entgegenhaltungen :
**DE-B- 2 461 245**
**US-A- 3 978 346**
**US-A- 3 984 751**

(73) Patentinhaber : **BBC Aktiengesellschaft Brown, Boveri & Cie.**
**Haselstrasse**
**CH-5401 Baden (CH)**

(72) Erfinder : **MAIER, Franz**
**Winzerstrasse 42 B**
**CH-5430 Wettingen (CH)**
Erfinder : **MAIER, Stephan**
**Winzerstrasse 42 B**
**CH-5430 Wettingen (CH)**

(74) Vertreter : **Kaiser, Helmut et al**
**BBC AG., Brown, Boveri & Cie Abt. ZP**
**CH-5401 Baden (CH)**

**Beschreibung**

Die vorliegende Erfindung betrifft eine Schaltungsanordnung zur Erzeugung von Hochleistungsimpulsen gemäss dem Oberbegriff von Patentanspruch 1.

Elektrische Hochleistungsimpulse mit Leistungen in einem Bereich zwischen 10 MW bis 1 GW werden in sehr unterschiedlichen Bereichen der Technik verwendet, beispielsweise zum Prüfen von Schaltern und Ventilableitern, zur Hochgeschwindigkeitsbearbeitung und insbesondere zum spannlosen Formen von Metall, für Impulsschmelzverfahren und zum Erzeugen von Schockwellen, mit denen Mineralien zerkleinert oder Abwässer entkeimt werden. Eine weitere wichtige Anwendung von Hochleistungsimpulsen ist das Induzieren eines Stroms im Plasmaring einer Anlage für die Kernfusion.

Die zum Erzeugen solcher Impulse erforderliche Leistung kann direkt aus einem Hochspannungsnetz oder einer elektrischen Maschine oder aus einem geeigneten Speicher entnommen werden. Weil Hochspannungsnetze im allgemeinen für eine impulsmässige Belastung nicht vorgesehen und darum auch wenig geeignet sind und brauchbare elektrische Maschinen, wie Schwungrad- oder Drehstromgeneratoren einen grossen apparativen Aufwand bedeuten, ist die Verwendung der relativ einfachen kapazitiven oder induktiven Speicher anzustreben, wobei wegen der vergleichsweise grösseren Energiedichte im magnetischen Feld der induktive Speicher vorzuziehen ist.

Eine Schaltungsanordnung der gattungsgemässen Art ist etwa aus der Fig. 3 der US-PS 3,984,771 bekannt. Bei dieser Anordnung befindet sich zwischen Stromquelle und induktivem Speicher ein Schalter mit einem Schaltthyristor und einem parallel zum Schaltthyristor angeordneten Löschkreis. Dieser Löschkreis enthält in Serie geschaltet einen Löschkondensator, eine Induktivität und einen Löschthyristor. Wird bei dieser Anordnung der Löschthyristor gezündet, so unterbricht ein vom Löschkondensator abgegebener Löschstrom kurzzeitig den durch den Schaltthyristor zum induktiven Speicher fliessenden Speisestrom, wodurch der Schaltthyristor geöffnet werden kann. Im vom induktiven Speicher und Entregungswiderstand gebildeten Entregungskreis zirkuliert nun ein Strom, welcher am induktiven Speicher einen Hochleistungsimpuls erzeugt. Bei dieser Schaltungsanordnung muss der Schalter jedoch grosse Ströme und Spannungen unterbrechen können. Ein solcher Schalter ist mit wirtschaftlich vertretbaren Mitteln jedoch nicht herstellbar.

Es ist Aufgabe der Erfindung eine Schaltungsanordnung der gattungsgemässen Art anzugeben, welche in einfacher und kostengünstiger Weise aufgebaut ist und gleichzeitig eine optimale Ausnützung der im induktiven Speicher vorhandenen Energie bei der Erzeugung Hochleistungsimpulsen gewährleistet.

Diese Aufgabe wird erfindungsgemäss durch die im kennzeichnenden Teil von Patentanspruch 1 angegebenen Merkmalen gelöst.

Wesentliche Vorteile der Erfindung ergeben sich daraus, dass der Speisestrom sehr rasch und zwangsläufig gleichzeitig in den Lösch- und einen Freilaufkreis kommutiert, wodurch die Verwendung eines für grosse Ströme und Spannungen ausgelegten Schalters entbehrlich ist. Die Synchronisierung des Einschaltimpulses für den Löschthyristor und das Unterdrücken des Einschaltsignals für den Schaltthyristor sind daher ohne besonderen technischen Aufwand möglich, so dass eine komplizierte Steuerelektronik entfällt.

Nachfolgend wird die Erfindung anhand von zwei in der Figur beschriebenen Ausführungsformen näher erläutert. Es zeigen:

Figur 1 das Prinzipschema einer ersten Ausführungsform der erfindungsgemässen Schaltungsanordnung, bei der ein Stromrichter an die Stromquelle angeschlossen ist, und bei der die Ventile des Stromrichters als Schaltthyristoren verwendet werden,

Figur 2 das Prinzipschema einer zweiten Ausführungsform der erfindungsgemässen Schaltungsanordnung, die an einen Hochstromgenerator angeschlossen ist und einen Schaltthyristor enthält und

Figur 3 den Stromverlauf im Primärkreis der Speicher-induktivität sowie im Schaltthyristor und Löschkondensator.

In der folgenden Beschreibung und in den genannten Figuren sind die jedem Fachmann bekannten Steuerkreise für Thyristoren der einfacheren Darstellung wegen weder beschrieben noch gezeigt.

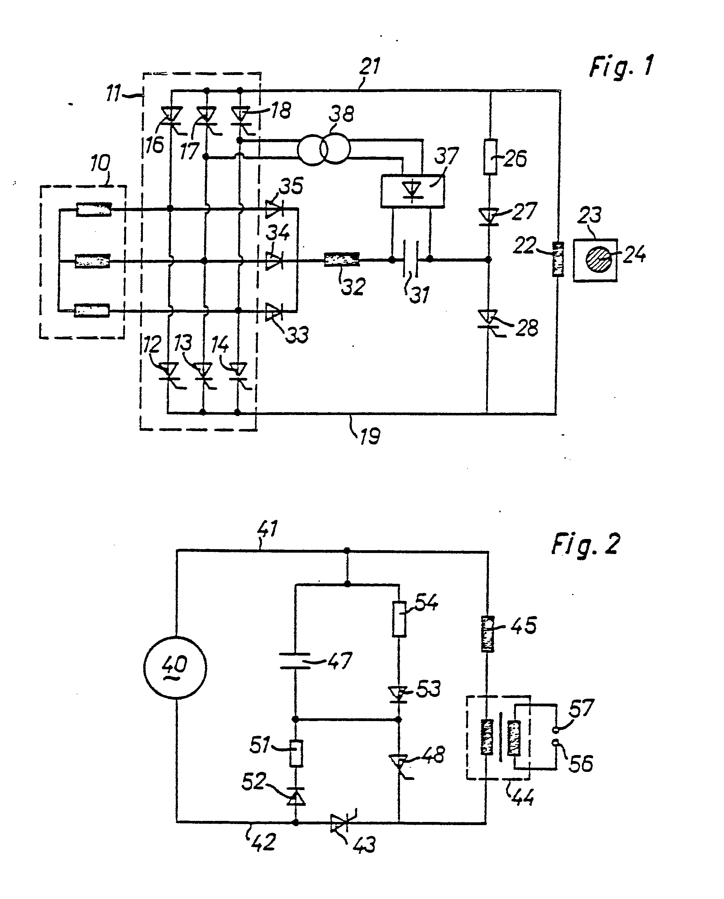

Die Fig. 1 zeigt schematisch die Sekundärwicklungen 10 eines Drei-Phasentransformators, die in bekannter Weise mit einer Gleichrichterbrücke 11 verbunden sind. Jede Seite dieser Brücke enthält drei Thyristoren 12, 13, 14 bzw. 16, 17, 18, deren Ausgänge mit einer Stromschiene 19 bzw. 21 verbunden sind. Die Stromschienen führen zu einer Induktivität 22, die mit einem magnetisierbaren Joch 23 zusammenwirkt, das einen Kanal 24 umfasst, der zum Führen des Plasmas in einer Kernfusionsanlage vorgesehen ist.

Parallel zur Induktivität ist ein Entladekreis geschaltet, dessen einer Zweig die Serieschaltung eines Entregungswiderstands 26 und einer Entkopplungs- oder Freilaufdiode 27 und dessen anderer Zweig einen gesteuerten Löschthyristor 28 enthält.

Der Löschkreis der Schaltung enthält einen Löschkondensator 31, dessen einer Anschluss mit dem Entladekreis und dessen anderer Anschluss über eine Löschdrossel und drei Entkopplungsdioden 33, 34, 35 mit je einer Phase der Sekundärwicklung des Drei-Phasentransformators verbunden ist. Die beiden Anschlüsse des Löschkondensators sind ausserdem mit dem Ausgang eines Ladegleichrichters 37 verbunden, der über einen Speisetransformator 38 an zwei der drei Phasen der Sekundärwicklung des Transformators angeschlossen ist.

Bei der Ausführung des Verfahrens mit der beschriebenen elektronischen Schaltung werden die Thyristoren 12, 13, 14 und 16, 17, 18 in den beiden Seiten der Gleichrichterbrücke derart angesteuert, dass in den Stromschienen 19, 21 ein Gleichstrom fliesst, der zum Aufbau eines starken Magnetfeldes in der Induktivität 22 führt. Während dieser Zeit ist der Löschthyristor 28 gesperrt und verhindert einen Stromfluss durch den Entregungskreis. Der Löschkondensator ist auf eine Spannung geladen, die etwas höher ist als der Spitzenwert der über die Brückenthyristoren 12, 13, 14 auf die Stromschiene 19 durchgeschalteten Spannung. Wenn die Induktivität aufgeladen ist und ein Hochleistungsimpuls erzeugt werden soll, wird dem Löschthyristor 28 ein Einschaltsignal zugeleitet und werden die Steuersignale an die Thyristoren in der Gleichrichterbrücke unterbrochen. Dann entlädt sich der Löschkondensator über die Stromschiene 19 durch den oder die stromleitenden Thyristoren 12, 13 und/oder 14, die entsprechende oder entsprechenden Entkopplungsdioden 33, 34 und/oder 35 und durch die Löschdrossel 32. Sobald bei diesem Vorgang der Entladestrom des Kondensators in einem der Thyristoren der Gleichrichterbrücke gleich dem entgegengerichteten Speicherstrom für die Induktivität ist, wird die Stromleitung durch den Thyristor unterbrochen. Nach dem Unterbrechen der Stromleitung in den Thyristoren 12, 13, 14 der einen Brückenseite entlädt sich der Löschkondensator weiter über die Induktivität 22, die Stromschiene 21 und den oder die zu diesem Zeitpunkt stromleitenden Thyristoren 16, 17 und/oder 18 und die entsprechenden nachgeschalteten Entkopplungsdioden 33, 34 bzw. 35 und die Löschdrossel 32, bis die wirksame Spannung auf die Durchlassspannung des oder der Thyristoren und Entkopplungsdioden abgesunken ist. Mit Beginn der Kommutierung des Ladestroms auf den höherohmigen Entregungskreis bricht durch die davon verursachte Stromänderung das Magnetfeld zusammen. Der dabei erzeugte Impuls wird von Joch 23 in das ionisierte Gas im Kanal 24, das als Sekundärteil des Uebertragers wirkt, eingeleitet und erzeugt dort einen Plasmastrom. Ein Teil der aus dem induktiven Speicher entnommenen Energie wird im Widerstand 26 in Wärme umgesetzt.

Die in Fig. 2 gezeigte Ausführungsform der elektronischen Schaltung enthält einen Gleichstromgenerator 40, der mit einer ersten Stromschiene 41 direkt und mit einer zweiten Stromschiene 42 über einen Schaltthyristor 43 und einen Impulsübertrager 44 mit einer Speicherinduktivität 45 verbunden ist. Parallel zum Gleichstromgenerator und Schaltthyristor ist ein Löchkreis angeschlossen, der einen Löschkondensator 47 und einen in Serie geschalteten Löschthyristor 48 enthält. Der Löschkondensator ist direkt mit der ersten Stromschiene 41 und über eine Ladediode 52 und einen Ladewiderstand 51 mit der zweiten Stromschiene 42 verbunden. Der Entladekreis enthält die Serieschaltung einer Freilaufdiode 53 und eines Entregungswiderstands 54, die über den Löschthyristor 48 parallel zur Serieschaltung von Speicherinduktivität und Impulsübertrager angeschlossen sind.

Der Sekundärteil des Impulsübertragers 44 ist mit zwei Elektroden 56, 57 verbunden, die zum Erregen von Schockwellen in dem zwischen den Elektroden befindlichen Medium vorgesehen sind.

Beim Erzeugen eines Hochleistungsimpulses mit der Schaltung gemäss Fig. 2 wird ein Auftastsignal an den Schaltthyristor 43 geleitet. Der dann einsetzende Strom im Lastkreis des Generators baut in der Speicherinduktivität 45 ein Magnetfeld auf, und zugleich wird der Löschkondensator 47 über die Diode 52 und den Widerstand 51 aufgeladen. Zum Erzeugen eines Hochleistungsimpulses wird dann ein Einschaltsignal an den Löschthyristor 48 geleitet und zugleich das Auftastsignal für den Schaltthyristor 43 unterbrochen. Dann entladet sich der Löschkondensator über den Löschthyristor, den Schaltthyristor und den Generator, wobei Löschstrom dem Laststrom entgegengerichtet ist und der Schaltthyristor in den nichtleitenden Zustand übergeht, sobald sich die beiden Ströme aufheben. Nach dem Unterbrechen des Stroms durch den Schaltthyristor 43 entladet sich der Löschkondensator weiter über den Impulsübertrager und die Speicherinduktivität.

Mit Beginn der Kommutierung des Ladestroms auf den Entregungskreis 54, 53, 48 setzt eine steile Aenderung des Stromes in den Induktivitäten 44 und 45 ein. Dabei wird ein Hochenergieimpuls im Sekundärteil des Uebertragers erzeugt, der an den Elektroden 56, 57 genutzt werden kann.

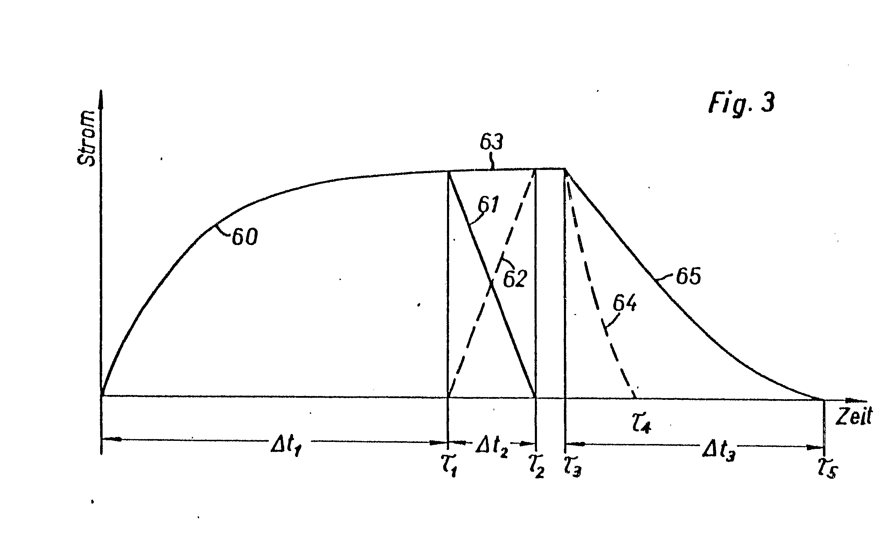

In Fig. 3 ist der errechnete zeitliche Stromverlauf im Primärkreis der Speicherinduktivität sowie im Schaltthyristor und Löschkondensator einer Schaltung gemäss der Fig. 2 aufgezeichnet. Im Anlehnung an die zum Erzeugen des Ringstroms in einer Tokamak-Kernfusionsanlage verwendeten Einrichtung war bei der Berechnung davon ausgegangen, dass die Induktivität des Speichers etwa 5 bis 50 mH beträgt und der Speicherstrom bis zu einem Maximalwert von 50 bis 100 kA ansteigt. Der Spitzenstrom im Plasma sollte etwa 1 bis 5 MA betragen, was einem Stromübersetzungsverhältnis von 1 : 20 bis 1 : 100 entspricht.

Bei geeigneter Wahl der Stromquelle steigt der Speicherstrom im Primärkreis entsprechend dem Kurventeil 60 an und erreicht nach einer Zeitspanne $\Delta t_1$ = 3 bis 8 sec seinen Maximalwert von etwa 100 kA. Wenn zum Zeitpunkt $\tau_1$ der Löschthyristor gezündet wird, beginnt das Kommutieren des Speicherstroms vom Schaltthyristor- auf den Löschkreis. Dabei sinkt der Strom durch den Schaltthyristor entsprechend dem Kurventeil 61 ab und erreicht nach der Zeitspanne $\Delta t_2$ = 200

bis 500 μsec bzw. zum Zeitpunkt $\tau_2$ den Wert Null. Zugleich steigt der vom Löschkondensator in den Primärkreis eingespeiste Strom entsprechend dem Kurventeil 62 an, bis er zum Zeitpunkt $\tau_2$ praktisch gleich gross ist wie der vorgängige Speicherstrom aus der Stromquelle. Weil beim Umkommutieren der vom Löschkondensator gelieferte Strom in der gleichen Weise ansteigt wie der Strom durch den Schaltthyristor abfällt, verläuft der Speicherstrom während der Zeitspanne $\Delta t_2$ entsprechend der für den Kurventeil 60 geltenden Gesetzmässigkeit, wie der Kurventeil 63 zeigt. Zum Zeitpunkt $\tau_2$ fliesst der gesamte Speicherstrom über den Löschkondensator, und der Schaltthyristor ist praktisch stromlos. Dann beginnt die Freihaltezeit für den Schaltthyristor, die etwa 200 bis 500 μsec beträgt. Während dieser Zeitspanne wird der Löschkondensator umgepolt, und ab dem Zeitpunkt $\tau_2$ kommutiert der Strom vom Löschkondensator auf den Entregungskreis und nimmt entsprechend dem Kurventeil 64 ab, bis er nach etwa 200 bis 400 μsec zum Zeitpunkt $\tau_4$ auf Null abgesunken ist. Zugleich kommutiert auch der Speicherstrom auf den Entregungskreis und sinkt während der Zeitspanne $\Delta t_3$, die im gerechneten Beispiel 1 bis 3 sec beträgt, entsprechend dem Kurventeil 65 auf Null ab.

Wie jeder Fachmann sofort erkennt, kann mit den beschriebenen Ausführungsformen der elektronischen Schaltungen der induktive Speicher allmählich während einer endlichen Zeit aufgeladen werden. Weiter kann der zeitliche Verlauf der Entladung des induktiven Speichers und damit auch die Form des Hochenergieimpulses durch die Wahl des Entladewiderstands 26 bzw. 54 beeinflusst werden. Dabei ist es möglich, anstelle des gezeigten einen Löschthyristors bzw. Schaltthyristors mehrere parallel geschaltete und synchron angesteuerte Thyristoren zu verwenden. Weiter versteht sich, dass zur Ausführung des erfindungsgemässen Verfahrens auch andere als die im Prinzipschema gezeigten elektronischen Schaltungen möglich sind. Insbesondere kann bei der Schaltung gemäss der Fig. 2 anstelle des Schalt- und des Löschthyristors 43 bzw. 48 im Verbindungspunkt von Lösch- und Entregungskreis mit der Stromschiene 42 auch ein mechanischer Wechselschalter verwendet werden.

**Patentansprüche**

1. Schaltungsanordnung zur Erzeugung von Hochleistungsimpulsen mit einem induktiven Speicher (22, 45), der über mindestens einen Thyristor an eine Stromquelle (10, 40) angeschlossen ist, sowie mit einem dem Thyristor zugeordneten Löschkreis mit einem Löschthyristor (28, 48) und einem dazu in Serie geschalteten Löschkondensator (31, 47) und mit einem dem induktiven Speicher (22, 45) parallelgeschalteten, einen Entregungswiderstand (26, 54) enthaltenden Entregungskreis, dadurch gekennzeichnet, dass der Löschkreis und der Entregungskreis einen gemeinsamen Stromzweig aufweisen, in welchem der Löschthyristor (28, 48) vorgesehen ist, und dass der den Entregungswiderstand enthaltende Stromzweig ein als Diode (27, 53) ausgebildetes Entkopplungsventil aufweist.

2. Schaltungsanordnung nach Anspruch 1, dadurch gekennzeichnet, dass der mindestens eine Thyristor Teil (12, ..., 18) einer Gleichrichterbrücke (11) ist (Fig. 1).

3. Schaltungsanordnung nach Anspruch 1, dadurch gekennzeichnet, dass der mindestens eine Thyristor als Schaltthyristor (43) in der Verbindungsleitung (42) zwischen der Stromquelle (40) und dem induktiven Speicher (45) angeordnet ist (Fig. 2).

**Claims**

1. Circuit arrangement for generating high-power pulses, comprising an inductive store (22, 45) which is connected via at least one thyristor to a current source (10, 40), and comprising a quenching circuit, which is associated with the thyristor, containing a quenching thyristor (28, 48) and a quenching capacitor (31, 47) which is connected in series with the former, and comprising a de-excitation circuit which contains a de-excitation resistor (26, 54) and which is connected in parallel with the inductive store (22, 45), characterised in that the quenching circuit and the de-excitation circuit have a common current branch in which the quenching thyristor (28, 48) is provided and that the current branch containing the de-excitation resistor is provided with a decoupling rectifier constructed as a diode (27, 53).

2. Circuit arrangement according to claim 1, characterised in that at least one thyristor is a part (12, ..., 18) of a rectifier bridge (11) (Figure 1).

3. Circuit arrangement according to Claim 1, characterised in that the at least one thyristor is arranged as switching thyristor (43) in the connecting line (42) between the current source (40) and the inductive store (45) (Figure 2).

**Revendications**

1. Dispositif de couplage pour la production d'impulsions à grande puissance, comportant un accumulateur inductif (22, 45), qui est raccordé à une source de courant (10, 40) par l'intermédiaire d'au moins un thyristor, un circuit d'amortissement associé au thyristor, avec un thyristor d'amortissement (28, 48) et avec un condensateur d'amortissement (31, 47), monté en série avec lui, ainsi qu'un circuit de désexcitation monté en parallèle avec l'accumulateur inductif (22, 45) et comprenant une résistance de désexcitation (26, 54), caractérisé en ce que le circuit d'amortissement et le circuit de désexcitation présentent une branche de courant commune dans laquelle est prévu le thyristor d'amortissement (28, 48) et en ce que la branche de courant comprenant la résistance de désexcitation comporte un élément redresseur de découplage constitué par une diode (27, 53).

2. Dispositif de couplage suivant la revendication 1, caractérisé en ce qu'au moins ledit thyristor est un élément (12, ..., 18) d'un redresseur en pont (11) (Fig. 1).

3. Dispositif de couplage suivant la revendication 1, caractérisé en ce qu'au moins ledit thyristor est monté comme thyristor de couplage (43) dans le conducteur de liaison (42) entre la source de courant (40) et l'accumulateur inductif (45) (Fig. 2).

*Fig. 1*

*Fig. 2*

1

Fig. 3

63

61

60

62

65

64

Strom

Zeit

$\Delta t_1$

$\tau_1$ $\Delta t_2$ $\tau_2$ $\tau_3$ $\tau_4$ $\Delta t_3$ $\tau_5$

0 067 156